# EUROPÄISCHE PATENTSCHRIFT

(11) **EP 1 012 976 B1**
(45) Veröffentlichungstag und Bekanntmachung des Hinweises auf die Patenterteilung: **28.11.2001**
(21) Anmeldenummer: 98939467.1
(22) Anmeldetag: 02.09.1998
(51) Int. Cl.: H03K 17/95

(54) **ANNÄHERUNGSSCHALTER**
PROXIMITY SENSOR
DETECTEUR DE PROXIMITE

(30) Priorität: 04.09.1997 CH 207397
(43) Veröffentlichungstag der Anmeldung: 28.06.2000
(73) Patentinhaber: HERA Rotterdam B.V., 3062 MA Rotterdam (NL)
(72) Erfinder: TANNER, Matthias, CH-8261 Hemishofen (CH); SCHLÄPFER, Bruno, CH-8523 Hagenbuch (CH)
(74) Vertreter: Patentanwälte Breiter + Wiedmer AG
(86) Internationale Anmeldenummer: CH9800378
(87) Internationale Veröffentlichungsnummer: WO9912260

(56) Entgegenhaltungen:
- EP-A- 0 479 078
- DE-A- 4 235 085
- US-A- 3 659 194
- US-A- 5 140 292

## Beschreibung

Die vorliegende Erfindung bezieht sich auf einen induktiven Annäherungsschalter für Temperatur- und Druckanwendungen, welcher im wesentlichen ein zylindrisches Gehäuse, eine stirnseitige Membrane, wenigstens eine Oszillatorspule mit Ferritkern und eine Elektronik umfasst, wobei die Wicklungsdrähte der Oszillatorspule mit Keramik isoliert sind.

Konventionelle mechanische Schalter werden zunehmend durch berührungslose Annäherungsschalter ersetzt. In induktiven Annäherungsschaltern beispielsweise sind Oszillatoren mit einem LC-Schwingkreis eingebaut, welche während dem Betrieb ein nach aussen gerichtetes, d.h. vom Gehäuse des Schalters weggerichtetes Wechselfeld erzeugen. Dieses Wechselfeld wird von sich dem Feld nähernden metallischen Körpern bedämpft, d.h. abgeschwächt, wobei sich das Verhalten des Feldes ändert.

Üblicherweise ist der Draht einer Oszillatorspule auf einen Ferritkern aufgewikkelt und die ganze Spule in einem hohlzylindrischen Gehäuse des Annäherungsschalters untergebracht. Die Oszillatorspule ist dabei etwa bündig mit dem zylindrischen Gehäuse verbunden.

Damit das Wechselfeld des Annäherungsschalters nach vorne in den freien Raum ausstrahlen kann, sind an sich bekannte Schutzabdeckungen vor der Oszillatorspule angeordnet, welche aus einem elektromagnetisch transparenten Material bestehen. Schutzabdeckungen aus Kunststoff sind erste Wahl, weil diese preiswert, einfach einpassbar und elektromagnetisch transparent sind. Bei extremen Temperaturanforderungen werden nach dem bekannten Stand der Technik temperaturbeständige Keramikscheiben verwendet, welche wohl teurer und schwieriger im Einbau sind, aber einen guten thermischen Schutz bieten, z.B. gegen heisse Späne oder Funken.

Sowohl Keramik- als auch Kunststoffmaterialien sind jedoch in Membranform nicht hochdruckbeständig. Um eine genügend hohe Druckfestigkeit zu erhalten, müsste die Membrandicke unverhältnismässig stark vergrössert werden. Dies wiederum hätte eine zu grosse Reduktion des Nutzschaltabstandes zur Folge.

Bekannte Oszillatorspulen von bekannten Annäherungsschaltern sind z.B. aus Standard-Ferritkernen und lackbeschichteten Kupferdrähten hergestellt, welche jedoch nur bis etwa 220°C temperaturfest sind.

Auch ist bei heute üblichen Annäherungsschaltern die Elektronik, d.h. die Oszillatorschaltung mit der ganzen Signalverarbeitung, im zylindrischen Schaltergehäuse untergebracht, was den Dauertemperaturbereich des ganzen Annäherungsschalters auf etwa 200 °C limitiert.

Heutige industrielle Prozesse, insbesondere Hochtemperaturprozesse, verlangen robuste, serienmässig hergestellte Annäherungsschalter, welche möglichst hohen Temperaturen und Drücken widerstehen, so beispielsweise in der Motorentechnik, der Raumfahrt oder in der Giessereitechnik.

Keiner der gegenwärtig auf dem Markt erhältlichen Annäherungsschalter erfüllt alle diese Kriterien. So wird beispielsweise in der EP,A1 0695036 ein hochdruckfester Annäherungsschalter beschrieben, welcher eine eingeschrumpfte Keramikscheibe als Membrane vorsieht. Eine solche Ausführung ist zwar hochtemperaturfest, aber nicht temperaturschockfest, da die unterschiedlichen Temperaturausdehnungskoeffizienten zwischen dem Gehäuse und der Membrane zu Rissen in der Keramik führen können. Ausserdem ist die Keramikscheibe spröde und daher nicht fest gegen hohe Druckbelastungen und/oder mechanische Einwirkungen von Schlägen mit Spitzen oder harten Teilen. Weiter können Keramikmembranen, wenn sie mit flüssigen Metallen oder Metallspuren in Kontakt treten, metallisieren und damit bedämpft werden, was die Anwendung in der Metall-, Giesserei- oder Hüttenindustrie wegen der Metallschicht ausschliesst oder zumindest stark erschwert.

Die DE,A1 4235085 beschreibt einen induktiven Sensor oder Geber und hat einen Spulenkörper mit einer Wicklung aus Litzen deren Einzeldrähte aus einer hochtemperaturbeständigen Legierung bestehen. Die Einzeldrähte sind durch von ihren Oberflächen getragenen Oxidschichten gegeneinander isoliert, welche auch ihrerseits hochtemperaturfest sind und aus nicht näher spezifizierten Oxiden bestehen. Verwendung finden die Sensoren insbesondere in einer induktiven Topferkennung für ein Kochfeld. Eine Hochdruckanwendung wird weder erwähnt noch angedeutet.

Die US,A 5140292 betrifft eine elektrische Spule mit einer darüberliegenden Glasfaserschicht. Die Erfindung gemäss dieser amerikanischen Patentschrift liegt in der Ausbildung dieser Glasfaserumhüllung. Vor dem Erhitzen werden Glasfaserbündel auf die primäre und sekundäre Wicklung aufgebracht. Dann werden die einzelnen Glasfasern angeschmolzen (vitrified), es bildet sich eine Glasmasse, in welcher die nicht vollständig geschmolzenen (non-vitrified) angeordnet sind. Es wird erwähnt, dass die beispielsweise aus einer Palladium-Silber-Legierung bestehenden primären und sekundären Wicklungen mit einer isolierenden Keramikbeschichtung versehen sind. Die beschriebenen Spulen werden insbesondere für Transformer verwendet und haben mit induktiven Annäherungsschaltem nichts zu tun.

In der EP,A1 0479078 wird ein Annäherungsschalter beschrieben, welcher in einem weiten Temperaturbereich von beispielsweise -25°C bis +100°C einen möglichst grossen Ansprechabstand zu einem sich nähernden Auslöser haben soll. In einem topfförmigen Metallgehäuse sind neben einer Sendespule stets zwei Sensorspulen im Wechselfeld angeordnet, welche die Differenz der in ihnen induzierten Spannungen erfassen. Diese beiden Sensorspulen sind so ausgebildet, dass die Differenzwechselspannung bei einem gewünschten Ansprechabstand zu null wird, was ein Schaltsignal auslöst. Bei druckfesten und explosionsgeschützten Annäherungsschaltern wird ein Gehäuse aus schlecht leitendem Metall mit geringer Permeabilität eingesetzt, beispielsweise Titan oder unmagnetische Stähle.

Der vorliegenden Erfindung liegt die Aufgabe zugrunde, einen induktiven Annäherungsschalter der eingangs genannten Art zu schaffen, welcher insbesondere hohen Temperaturen und Drücken standhält, sehr robust ist und nur geringe temperaturbedingte Bedämpfungsänderungen aufweist.

Die Aufgabe wird erfindungsgemäss nach dem Kennzeichen von Patentanspruch 1 gelöst. Spezielle und weiterbildende Ausführungsformen des Annäherungsschalter sind Gegenstand von abhängigen Patentansprüchen.

Vorzugsweise besteht die Membrane und allenfalls das Gehäuse wenigstens in deren Bereich aus einem hochtemperaturfesten, temperaturschockbeständigen metallischen Material, welches über den Nenntemperaturbereich keine oder eine dem Feldverlust der Oszillatorspule entgegengesetzt entsprechende Bedämpfungsänderung bewirkt.

Mit der Ausbildung von Membranen und Gehäusen oder wenigstens des der Membrane benachbarten Teils des Gehäuses aus einem hochtemperaturfesten metallischen Material werden bekannte Annäherungsschalter in mehrfacher Hinsicht verbessert:
- Die zweckmässig einstückig ausgebildeten Membrane und Gehäuse sind nicht nur hochtemperatur-, sondern insbesondere auch temperaturschockbeständig.
- Die Bedämpfung des vom Oszillator des Annäherungsschalters ausgesandten Wechselfeldes wird im Nenntemperaturbereich nicht geändert oder kompensiert.

Von wesentlicher Bedeutung sind die Wicklungsdrähte der Oszillatorspule. Diese bestehen vorzugsweise aus keramikbeschichtetem Silber, Nickel, Platin oder Kupferberyllium.

Von wesentlicher Bedeutung ist weiter die bevorzugte Anordnung des Oszillators mit seinem LC-Schwingkreis. Lediglich die Oszillatorspule ist im Gehäuse des Annäherungsschalters angeordnet, die ganze Elektronik wird mit einem Kabel aus dem Gehäuse an einen weniger exponierten Ort geleitet. Selbstverständlich können auch zwei oder mehr Oszillatorspulen eingebaut sein, welche coaxial und/oder nebeneinander angeordnet sind. Dadurch wird erreicht, dass die Temperaturempfindlichkeit vermindert und die Signalstärke erhöht wird.

Die Erfindung wird anhand von in der Zeichnung dargestellten Ausführungsbeispielen, welche auch Gegenstand von abhängigen Patentansprüchen sind, näher erläutert. Es zeigen schematisch:
- Fig. 1 eine geschnittene Seitenansicht eines hochtemperatur- und hochdruckbeständigen Annäherungsschalters mit einem separaten Oszillatorteil,
- Fig. 2 eine geschnittene Seitenansicht des Annäherungsschalters,
- Fig. 3 eine Variante von Fig. 2,
- Fig. 4 ein ideales Temperaturverhalten eines Annährungsschalters,
- Fig. 5 einen in eine Bohrung eingebauten Annährungsschalter, und
- Fig. 6 einen als Druckaufnehmer ausgestalteten Annährungsschalter.

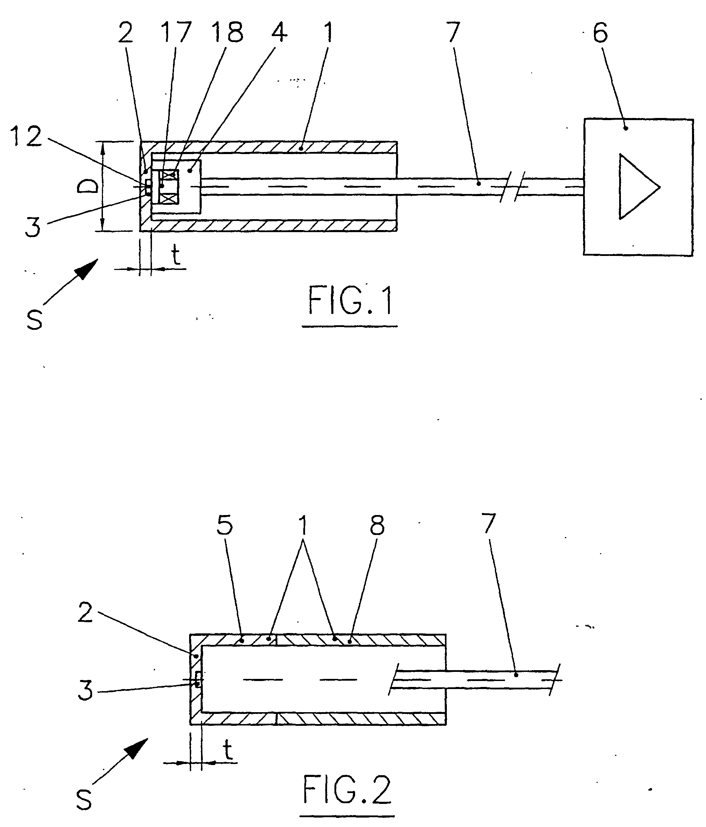

Ein in Fig. 1 dargestellter Annäherungsschalter S weist ein zylindrisches Gehäuse 1 mit einer stimseitigen Membrane 2 und einem nicht erkennbaren Aussengewinde auf. Das Gehäuse 1 und die Membrane 2 bestehen aus demselben hochtemperaturfesten Material mit möglichst kleiner Bedämpfung, wie z.B. ferritische Materialien, V2A-Stahl, einer Titanlegierung, Kupferberyllium (CuBe) oder einem anderen metallischen Material mit entsprechenden Eigenschaften, insbesondere einer hohen Temperaturschockbeständigkeit.

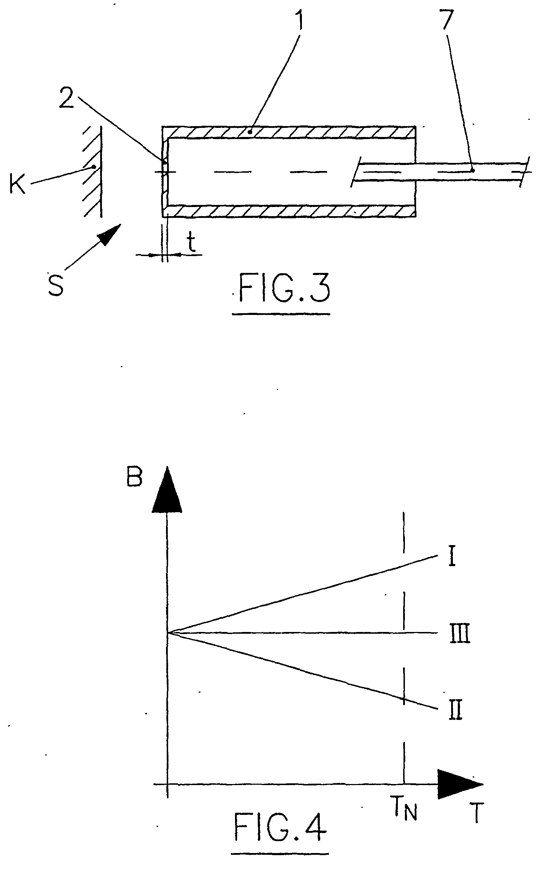

Die metallische Membrane 2 ist so dick ausgeführt, dass sie Drücken bis zum Nennbereich des Annäherungsschalters S sicher standhält. Ihre Dicke t ist vom Druckbereich und vom Aussendurchmesser D des Annäherungsschalters S abhängig, sie wird nach an sich bekannten Methoden berechnet. Die Bedämpfung des hochfrequenten elektrischen Wechselfeldes durch die metallische Membrane 2, welche bei erforderlicher Hochdruckbeständigkeit dick ausgeführt sein muss, wird teilweise kompensiert durch wenigstens eine innenseitige Aussparung 3 in der Membrane 2. Jede dieser Aussparungen 3 ist mit wenigstens einer passenden Ferritpille 12 gefüllt, welche das Wechselfeld näher an einen zu detektierenden metallischen Körper K (Fig. 3) führt und damit ein höheres Nutzsignal bringt. Die Aussparungen 3, zweckmässig Ausfräsungen, beeinträchtigen die Druckfestigkeit der Membrane 2 nur unwesentlich, insbesondere wenn lediglich eine zentrale Aussparung 3 ausgebildet ist, was überdies gute Resultate bezüglich des Schaltabstands bringt.

Direkt innerhalb der Membrane 2 ist eine Oszillatorspule 4 angeordnet und über ein, falls erforderlich temperaturfestes Kabel 7 beliebiger Länge mit einer externen Elektronik 6 verbunden. Diese Oszillatorspule 4 besteht aus einem hochtemperaturfesten Ferritkern 17 und einer Wicklung 18 aus einem keramikisolierten Leiter, wodurch insgesamt eine hohe Temperaturfestigkeit gewährleistet ist. Nach dem Einbau wird die gesamte Oszillatorspule 4 zweckmässig mit dem Kabel 7 vergossen. Oszillatorspule 4 und Kabel 7 können aber auch mechanisch verspannt sein.

In Fig. 2 wird eine Ausführungsform eines Annäherungsschalters dargestellt, nach welcher nur der Kopfteil 5 des Gehäuses 1 mit einer stirnseitigen Membrane 2 aus dem vorstehend beschriebenen hochfesten Material hergestellt ist. Der restliche rohrförmige Teil 8 des Gehäuses 1 ist aus einem anderen Material gefertigt, welches kostengünstiger und/oder einfacher bearbeitbar ist, beispielsweise aus einem gut bearbeitbaren Stahl, Aluminium oder Messing. Nach einer weiteren, nicht dargestellten Variante kann auch nur die stimseitige Membrane 2 aus dem hochfesten Material gefertigt sein.

Fig. 3 zeigt eine Ausführungsform eines Hochtemperatur-Annährungssensors S, welcher nicht gemäss der Erfindung für hohe Druckbeanspruchungen ausgelegt ist. Dadurch ist nur eine wesentlich dünnere Membrane 2 erforderlich, sie liegt nur noch im Bereich eines Milimeterbruchteils, z.B. 0,1 - 1 mm, insbesondere 0,2 - 0,5 mm, gegenüber 1,5 bis 3 mm gemäss Fig. 1 und 2. Eine gemäss Fig. 3 dünner ausgebildete Membrane 2 ist durchlässiger für das elektromagnetische Wechselfeld, deshalb kann der Schaltabstand des Annäherungssensors S vergrössert werden. Durch den geringeren Schaltabstand sinkt die Bedämpfung durch die Membrane 2 und steigt das Signal eines sich im Wechselfeld nähernden metallischen Körpers K beträchtlich, ohne dass sich die Hochtemperaturbeständigkeit ändert.

In Fig. 4 ist ein ideales Temperaturverhalten des Annäherungsschalters S (Fig. 1 bis 3) dargestellt. Es wird gezeigt, wie eine günstige Materialwahl die Temperatureinflüsse über einen Nenntemperaturbereich T_{N} aufheben oder wenigstens teilweise kompensieren kann. Auf der Abszisse ist die Temperatur T, auf der Ordinate die infolge der Bedämpfung resultierende Temperaturempfindlichkeit der Feldstärke B des Wechselfeldes auf Annäherung von metallischen Körpern K (Fig. 3) aufgetragen. Bevorzugt resultiert eine horizontale Linie, d.h. die vollständige Temperaturunabhängigkeit.

Kurve I zeigt die Feldstärke B bei Abnahme der Bedämpfung durch das als Membrane 2 (Fig. 1 bis 3) verwendete metallische Material. Die Bedämpfung nimmt mit steigender Temperatur T ab, wodurch stärkere Signale entstehen. Kurve II stellt das Verhalten der Oszillatorspule 4 (Fig. 1) dar, welche mit zunehmender Temperatur T mit den meisten Materialien an Feldstärke B verliert. Die Kurve I steigt vorzugsweise im selben Winkel, wie Kurve II sinkt. Bei günstiger Materialwahl heben sich die unerwünschten Temperatureffekte gemäss Kurve I und II auf, der Annäherungsschalter S ist somit temperaturkompensiert, wie dies in der resultierenden Kurve III dargestellt ist.

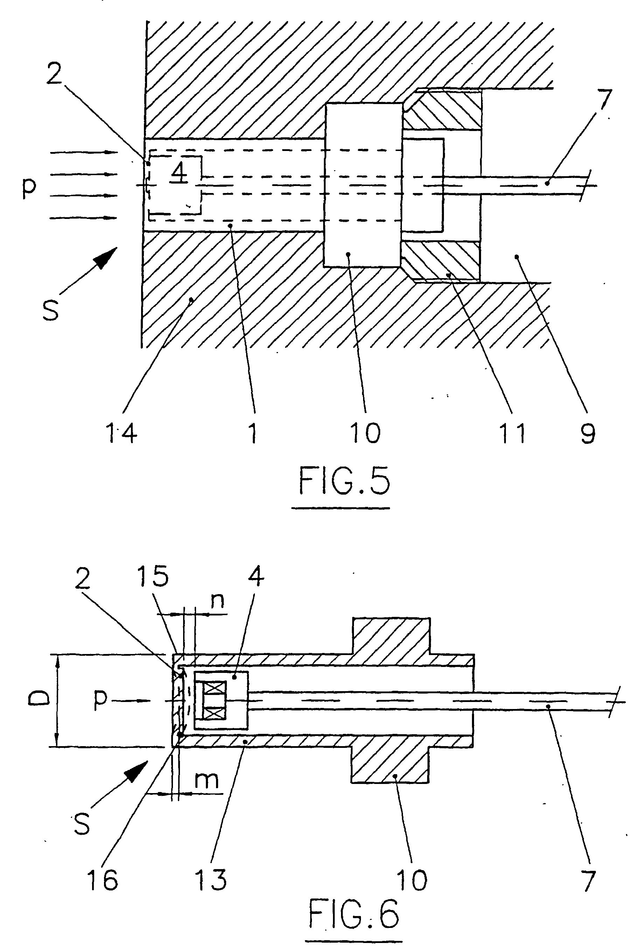

Eine mechanische Ausführungsform des Annäherungsschalters S ist in Fig. 5 ersichtlich. Der Annäherungsschalter S wird in eine vorbereitete, abgesetzte Bohrung 9 in einem Bauteil 14 geschoben und unter Einwirkung einer Mutter 11 mit dem Bund 10 in die Bohrung 9 verspannt. Dadurch werden auch sehr hohe auf die Membrane 2 einwirkende Drücke p durch die Mutter 11 sicher aufgenommen.

Fig. 6 zeigt einen als hochtemperaturbeständiger Drucksensor 13 ausgebildeten Annährungsschalter S. Die Oszillatorspule 4 hat von der Membrane 2 den Abstand n. Dieser Abstand n muss in jedem Fall grösser sein als die Durchbiegung m der Membrane 2 unter·Einwirkung des Drucks p. Die Membrane 2 kann in irgendeinem bedämpfenden Material ausgeführt sein, wobei sich insbesondere ferritische Materialien bewährt haben. Die Membrane 2 ist in an sich bekannter Weise als Druckmembrane so ausgebildet, dass sie sich bei einem Druck p in Richtung der Oszillatorspule 4 um m durchbiegt und die Oszillatorspule 4 bedämpft. Die Bedämpfung ist eine Funktion der druckbedingten Durchbiegung um m und somit reproduzierbar, falls erforderlich auch linearisierbar. Es können beispielsweise hohe Drücke im Bereich von 2000 bar gemessen werden, auch bei hohen Temperaturen bis weit oberhalb der heutigen Grenze von etwa 200°C, z.B. im Bereich von 500°C. Die Membrandicke t (Fig. 1 bis 3), der Durchmesser D und die Membraneinleitung am Gehäuserand 15 bestimmen das Ausgangssignal und damit den Druckbereich des hier beschriebenen hochtemperaturbeständigen Drucksensors 13. Dieser kann mittels eines Bunds 10 oder mit einem Aussengewinde wie andere Drucksensoren eingebaut werden. Die erwähnte Membraneinleitung am Gehäuserand 15 umfasst vorliegend eine innenseitig kreisförmig umlaufende Nut 16.

### Beispiel 1

Eine Oszillatorspule 4 eines Annäherungsschalters S umfasst einen sehr dünnen Silberdraht mit einer Keramikisolation aus Aluminiumoxid und/oder Siliziumoxid. Die keramische Isolationsschicht ist im Anlieferungszustand biegbar. Nach einem ersten Aufheizzyklus auf die Kristallisationstemperatur erreicht die keramische Isolationsschicht die geforderte Endfestigkeit. Als Drahtmaterial kann anstelle von Silber insbesondere Nickel, Platin, eine spezielle Kupferlegierung, wie Kupferberyllium, und andere leitende Metalle verwendet werden. Die Schichtdicke der keramischen Isolationsschicht ist gering, zweckmässig liegen die Schichtdicken zwischen 0.005 und 0.02 mm. Besonders gute Resultate werden erreicht, wenn für die Oszillatorspulen 4 (Fig.1) Ferritkeme 17 (Fig.1) aus Nickel/Zink-Legierungen eingesetzt werden, weil diese eine hohe Curie-Temperatur aufweisen.

### Beispiel 2

Nach dem üblichen Stand der Technik sind Membrandicken t von weniger als 1 mm üblich. Die Membrandicken der vorliegenden Annährungsschalter S können mit Dicken t im Bereich von 1,5 bis 3 mm ausgeführt werden (Fig. 1, 2). Die Dicke des Gehäuses liegt im selben Bereich. Ausgenommen ist die spezielle Ausführungsform gemäss Fig. 3. Besonders gute Resultate werden erreicht, wenn die Membrandicke etwa 2 mm beträgt und im Zentrum in einer Aussparung 3 eine entsprechende Ferritpille 12 von etwa 1 mm Dicke eingesetzt ist. Diese Pille kann auch dünner oder dicker sein. Bei der Ausbildung von mehreren Aussparungen 3 kann auch eine entsprechende Zahl Ferritpillen 12 eingelassen sein.

## Patentansprüche

1. Induktiver Annäherungsschalter (S) für Temperatur- und Druckanwendungen, welcher im wesentlichen ein zylindrisches Gehäuse (1), eine stirnseitige Membrane (2), wenigstens eine Oszillatorspule (4) mit Ferritkern (17) und eine Elektronik (6) umfasst, **dadurch gekennzeichnet, dass** die Wicklungsdrähte der Oszillatorspule (4) mit Keramik isoliert sind, und
die Oszillatorspule (4) um die Distanz (n) von der Membrane (2) entfernt eingebaut und dadurch die druckabhängige Durchbiegung (m) der Membrane (2) mit der Oszillatorspule (4) als Drucksignal detektierbar ist.

2. Annäherungsschalter (S) nach Anspruch 1, **dadurch gekennzeichnet, dass** die Membrane (2) und ein allfälliger Kopfteil (5) des Gehäuses (1) im Membranbereich aus einem hochtemperaturfesten, temperaturschockbeständigen metallischen Material besteht, welches über den Nenntemperaturbereich (T_{N}) keine oder eine dem Feldverlust der Oszillatorspule (4) entgegengesetzt entsprechende Bedämpfungsänderung bewirkt.

3. Annäherungsschalter (S) nach Anspruch 1 oder 2, **dadurch gekennzeichnet, dass** die Wicklungsdrähte der Oszillatorspule (4) aus Silber, Nickel, Platin oder einer Kupferlegierung, insbesondere Kupferberyllium, bestehen.

4. Annäherungsschalter (S) nach einem der Ansprüche 1 bis 3, **dadurch gekennzeichnet, dass** die über ein Kabel (7) angeschlossene Elektronik (6), ausserhalb des Gehäuses (1) angeordnet ist.

5. Annäherungsschalter (S) nach einem der Ansprüche 1 bis 4, **dadurch gekennzeichnet, dass** in einer 1,5 bis 3 mm dicken metallischen Membrane (2) wenigstens eine Aussparung (3) vorgesehen ist.

6. Annäherungsschalter (S) nach Anspruch 5, **dadurch gekennzeichnet, dass** in der Aussparung (3) wenigstens eine Ferritpille (12) angeordnet ist.

7. Annäherungsschalter (S) nach einem der Ansprüche 1 bis 6, **dadurch gekennzeichnet, dass** das rohrförmige Gehäuse (1) ausserhalb des Bereichs der Membrane (2) aus einem bearbeitbaren Material besteht.

8. Annäherungsschalter (S) nach Anspruch 7, **dadurch gekennzeichnet, dass** das rohrförmige Gehäuse ausserhalb des Bereichs der Membrane (2) aus Stahl, Aluminium oder Messing besteht.

9. Annäherungsschalter (S) nach einem der Ansprüche 1 bis 8, **dadurch gekennzeichnet, dass** das Gehäuse (1) im von der Membrane (2) abgewandten Teil einen diagonal nach aussen abkragenden Bund (10) aufweist.

10. Annäherungsschalter (S) nach einem der Ansprüche 1 bis 9, **dadurch gekennzeichnet, dass** die Membrane (2) und wenigstens der ihr benachbarte Teil des Gehäuses (1) aus ferritischen Materialien, V2A-Stahl, einer Titanlegierung oder Kupferberyllium bestehen.

## Claims

1. Inductive proximity switch (S) for temperature and pressure applications which substantially comprises a cylindrical housing (1), an end membrane (2), at least one oscillator coil (4) with ferrite core (17) and an electronic unit (6), **characterised in that** the winding wires of the oscillator coil (4) are insulated with ceramic, and the oscillator coil (4) is fitted remote from the membrane (2) by a distance (n) and hence the pressure-dependent flexion (m) of the membrane (2) can be detected as a pressure signal by the oscillator coil (4).

2. Proximity switch (S) according to claim 1, **characterised in that** the membrane (2) and where applicable a head part (5) of the housing (1) in the membrane area consists of a metal material resistant to high temperature and temperature shock which over the nominal temperature range (T_{N}) causes no damping change, or a damping change corresponding inversely to the field loss of the oscillator coil (4).

3. Proximity switch (S) according to claim 1 or 2, **characterised in that** the winding wires of the oscillator coil (4) are made of silver, nickel, platinum or a copper alloy, in particular copper beryllium.

4. Proximity switch (S) according to any of claims 1 to 3, **characterised in that** the electronic unit (6) connected by way of a cable (7), is arranged outside the housing (1).

5. Proximity switch (S) according to any of claims 1 to 4, **characterised in that** at least one recess (3) is provided in a metal membrane (2) 1.5 to 3 mm thick.

6. Proximity switch (S) according to claim 5, **characterised in that** in the recess (3) is arranged at least one ferrite pill (12).

7. Proximity switch (S) according to any of claims 1 to 6, **characterised in that** outside the area of the membrane (2), the tubular housing (1) consists of a machinable material.

8. Proximity switch (S) according to claim 7, **characterised in that** outside the area of the membrane (2), the tubular housing consists of steel, aluminium or brass.

9. Proximity switch (S) according to any of claims 1 to 8, **characterised in that** in the part facing away from the membrane (2), the housing (1) has a collar (10) projecting diagonally outwards.

10. Proximity switch (S) according to any of claims 1 to 9, **characterised in that** the membrane (2) and at least the part of the housing (1) adjacent to this consist of ferrite materials, V2A steel, a titanium alloy or copper beryllium.

## Revendications

1. Détecteur de proximité de type inductif (S), pour des utilisations à des températures et des pressions élevées, qui comprend un boîtier cylindrique (1), une membrane frontale (2), au moins une bobine d'oscillation (4) comportant un noyau de ferrite (17) et un circuit électronique (6), **caractérisé en ce que** les fils de l'enroulement de la bobine d'oscillation (4) sont isolés avec de la céramique et **en ce que** la bobine d'oscillation (4) est insérée à une distance (n) de la membrane (2) de telle sorte que le fléchissement (m) de la membrane (2) en fonction de la pression peut être détecté en tant que signal de pression par la bobine d'oscillation (4).

2. Détecteur de proximité (S) selon la revendication 1, **caractérisé en ce que** la membrane (2) et une éventuelle partie de tête (5) du boîtier (1) disposée dans la zone de la membrane (2) sont réalisés en une matière métallique qui résiste aux températures élevées et aux chocs thermiques et qui, dans la zone des températures supérieures à la température nominale (T_{N}), ne crée pas de modification de l'amortissement ou crée une modification de l'amortissement correspondante dans le sens opposé à la perte de champ de la bobine d'oscillation (4).

3. Détecteur de proximité (S) selon la revendication 1 ou 2, **caractérisé en ce que** les fils de l'enroulement de la bobine d'oscillation (4) sont en argent, en nickel, en platine ou en alliage de cuivre, en particulier en cuivre au béryllium.

4. Détecteur de proximité (S) selon l'une quelconque des revendications 1 à 3, **caractérisé en ce que** le circuit électronique (6) est disposé à l'extérieur du boîtier (1) et relié par un câble (7).

5. Détecteur de proximité (S) selon l'une quelconque des revendications 1 à 4, **caractérisé en ce que** l'on prévoit au moins un évidement (3) dans une membrane métallique (2) dont l'épaisseur est comprise entre 1,5 et 3 mm.

6. Détecteur de proximité (S) selon la revendication 5, **caractérisé en ce que** l'on dispose au moins une pastille de ferrite (12) dans l'évidement (3).

7. Détecteur de proximité (S) selon l'une quelconque des revendications 1 à 6, **caractérisé en ce que** le boîtier tubulaire (1) est réalisé, à l'extérieur de la zone de la membrane (2), en une matière pouvant être usinée.

8. Détecteur de proximité (S) selon la revendication 7, **caractérisé en ce que** le boîtier tubulaire (1) est réalisé, à l'extérieur de la zone de la membrane (2), en acier, en aluminium ou en laiton.

9. Détecteur de proximité (S) selon l'une quelconque des revendications 1 à 8, **caractérisé en ce que** le boîtier (1) comporte, dans sa partie opposée à la membrane (2), une collerette (10) formant un col disposé transversalement vers l'extérieur.

10. Détecteur de proximité (S) selon l'une quelconque des revendications 1 à 9, **caractérisé en ce que** la membrane (2) et au moins la partie du boîtier (1) qui en est proche sont réalisés en matière ferritique, en acier V2A, en un alliage de titane ou en cuivre au béryllium.
